# EUROPEAN PATENT APPLICATION

(11) **EP 4 838 735 A1**
(43) Date of publication of application: **11.11.2026**
(21) Application number: 25175318.2
(22) Date of filing: 09.05.2025
(51) Int. Cl.: H02J 3/00, G01R 19/25, G01R 27/16, H02J 3/36

(54) **IMPROVEMENTS RELATING TO CHARACTERISING FREQUENCY-DEPENDENT BEHAVIOUR OF INTERCONNECTED SYSTEMS IN POWER GRIDS**

(71) Applicant: GE Vernova Technology GmbH, 5400 Baden (CH)
(72) Inventor: KANNAN, Shrinath, SN 01099 Dresden (DE); JASIM, Omar, Stafford, ST16 1WS (GB); O'HEIDHIN, Gearoid, Stafford, ST16 1WS (GB); YURT, Ceren, 12277 Berlin (DE)
(74) Representative: Openshaw & Co.

(57) **Abstract**

There is provided a method (300) of determining a frequency-dependent impedance at a point of interest in a polyphase power grid, wherein the polyphase power grid comprises a plurality of interconnected systems. The method (300) comprises determining (310), for a point of interest in the polyphase power grid, a first alternating current (AC) voltage data and a first AC current data. The method (300) comprises injecting (320) at the point of interest, for each electrical phase or on each electrical sequence, a plurality of perturbation signals, wherein the plurality of perturbation signals comprises AC current signals at a plurality of frequencies. The method (300) comprises determining (330), for the point of interest, a second AC voltage data and a second AC current data in response to each perturbation signal, at the plurality of frequencies and for each electrical phase or electrical sequence. The method (300) comprises calculating (340), based on the first AC voltage data, first AC current data, second AC voltage data and the second AC current data, the frequency-dependent impedance.

## Description

### Field

The subject matter herein relates generally to the field of power grids and more specifically to the characterization of frequency-dependent behaviour of interconnected systems in power grids.

### Introduction

A power grid is an interconnected system of infrastructure to generate, transmit and distribute power. Typically, a power grid will include alternating current (AC) sources and loads, including power generation networks such as renewable power generation plants, wind farms, and solar farms. The power grid will also include AC consumer networks. For the transmission and distribution of power a power grid may also include AC power transmission networks and/or high voltage direct current (HVDC) power transmission networks.

In HVDC power transmission networks, AC power is typically converted to DC power for transmission via overhead lines, under-sea cables and/or underground cables. This conversion removes the need to compensate for the AC reactive/capacitive load effects imposed by the power transmission medium, i.e. the transmission line or cable, and reduces the cost per kilometre of the lines and/or cables, and thus becomes cost-effective when power needs to be transmitted over a long distance. DC power can also be transmitted directly from offshore wind parks to onshore AC power transmission networks, for instance.

The conversion between DC power and AC power is utilised where it is necessary to interconnect DC and AC networks. In any such power transmission network, power conversion means also known as power converters, located in converter stations, are required at each interface between AC and DC power to effect the required conversion from AC to DC or from DC to AC.

The choice of the most suitable HVDC power transmission network or scheme depends on the particular application and scheme features and the characteristics of the power grid into which the HVDC scheme is being deployed. Examples of power transmission networks include monopole power transmission networks and bipole power transmission networks.

### Summary

When integrating a power transmission network into a power grid, the integration needs to consider a number of factors that can affect the overall stability and operation of the power grid. For example, the power transmission network will have its own characteristics that could influence or affect behaviour of the power grid. Equally, other systems in the power grid will also have their own characteristics that could influence or affect behaviour of the power transmission network. Collectively, these characteristics may have undesirable effects that are evident in the time domain and/or in the frequency domain when the power transmission network and wider power grid are interconnected.

Network designers may analyse such characteristics in order to ensure that power transmission is both balanced and stable. This analysis may be performed as part of the design phase of a power grid or power transmission network, and/or once the power transmission network has been deployed. Analysis solely in the time domain does not of itself account fully for the effects of harmonic frequencies of voltage and current that can be introduced by power electronic systems such as power converters (i.e., modular multilevel converters) typically used in modern power transmission schemes (such as HVDC schemes). Accordingly, it is also necessary to analyse how a power grid of interconnected systems behaves in the frequency domain.

Frequency scanning is an approach that can be used by network designers to determine the behaviour of power grids and their interconnected systems in the frequency domain. During a frequency scan, the power grid tends to be operated under stable operating conditions to ensure normal system phenomena (such as non-linearities) are present. Signal injection is then used at a point of interest to inject relatively small magnitude signals on top of the normal AC voltage or AC current being observed. The injected signals tend to have frequencies different to the nominal frequency (for instance 50Hz) at the point of interest in the power grid. The signals may be injected together as a superposition, or individually, in order to create a perturbation against which the power grid will respond. The response, as a voltage and/or current can then be measured and used to determine variables such as impedances at the point of interest. Such variables are particularly useful for rating the performance of interconnected systems, such as power transmission networks, or in the design phase of interconnected systems (for instance to mitigate impedance mismatches).

Whilst frequency scanning can be beneficial in the design, implementation and operation of power grids and power transmission networks, there has been an assumption that interconnected systems (for instance plural power converters) behave similarly in the frequency-domain and hence can be characterized in isolation. This assumption tends to severely limit the complete frequency-dependent characterization of several interconnected systems.

Furthermore, there has been an assumption that the harmonic emissions produced by the interconnected systems are negligible under operating conditions. This tends to result in inaccurate measurements of frequency-dependent impedance characteristics of interconnected systems.

Furthermore, there has been an assumption that the different electrical phases or electrical sequences at a point of interest in a polyphase power grid (for instance the three phases of three-phase grids) do not interact with each other at harmonic frequencies. Accordingly, frequency scanning has tended to focus solely on injecting signals and measuring system responses on the same electrical phase or as part of the same electrical sequence. This also tends to result in undiagnosed power quality and harmonic stability issues.

It is desirable to provide a method of determining a frequency-dependent impedance at a point of interest in a polyphase power grid and device for the same that mitigates these issues.

According to a first aspect, there is provided a method of determining a frequency-dependent impedance at a point of interest in a polyphase power grid, wherein the polyphase power grid comprises a plurality of interconnected systems, the method comprising: determining, for a point of interest in the polyphase power grid, a first alternating current (AC) voltage data and a first AC current data, wherein the first AC voltage data and the first AC current data respectively comprise first AC voltage measurements and first AC current measurements at a plurality of frequencies in a predetermined frequency range for each electrical phase or electrical sequence of the polyphase power grid; injecting at the point of interest, for each electrical phase or on each electrical sequence, a plurality of perturbation signals, wherein the plurality of perturbation signals comprise AC current signals at the plurality of frequencies; determining, for the point of interest, a second AC voltage data and a second AC current data, wherein the second AC voltage data and the second AC current data respectively comprise second AC voltage measurements and second AC current measurements in response to each perturbation signal, wherein the AC voltage measurements and AC current measurements are at the plurality of frequencies and for each electrical phase or electrical sequence; and calculating, based on the first AC voltage data, first AC current data, second AC voltage data and the second AC current data, the frequency-dependent impedance.

The method may be a computer-implemented method. The method may be considered to be a method of characterizing the frequency-dependent behaviour of an impedance at a point of interest in a power grid.

The inventors have found that performing frequency scanning by injecting signals injected on a given electrical phase or electrical sequence (positive, negative, zero sequence) but then determining responses across all electrical phases or electrical sequences, tends to yield improved insights into the frequency-dependent behaviour of a power grid. More specifically, the inventors have identified that the method can more accurately characterize the extremity of impedance mismatches or harmonic unbalances at specific frequencies in a power grid. These insights tend to enable network designers to more effectively optimize network design and/or design, deploy and operate appropriate mitigations such as passive filters or active damping. Furthermore, such a method can be used to mitigate maloperation of harmonic filters and the unstable operation of a power grid.

The determining the first AC voltage measurements and the first AC current measurements may comprise determining any pre-existing distortion at the point of interest.

The injecting may be performed using a current source. The injecting may be performed for each electrical phase or electrical sequence and for each frequency. For example, a first perturbation signal may be injected for a first phase and at a first frequency with the second voltage and second current measurements being obtained for all phases. This process may be repeated for further perturbation signals at other frequencies for the first phase. Then, the perturbation signals may be provided to the second phase and the second voltage and second current measurements obtained for all phases. Finally, the perturbation signals may be provided to the third phase and the second voltage and second current measurements obtained for all phases. Expressed differently, the injection procedure may be performed on each phase one at a time but with the response determined across all phases in each case, and for each frequency of perturbation.

The calculating, based on the first AC voltage data, first AC current data, second AC voltage data and the second AC current data, the frequency-dependent impedance, may comprise: determining a plurality of AC voltage and AC current deviations for each frequency in the plurality of frequencies and for each electrical phase or electrical sequence, wherein the plurality of AC voltage and AC current deviations are based on the first AC voltage data, the first AC current data, the second AC voltage data and the second AC current data; and then calculating, based on the plurality of AC voltage and AC current deviations, the frequency-dependent impedance.

The calculating, based on the plurality of AC voltage and AC current deviations, the frequency-dependent impedance, may comprise calculating, for each frequency in the plurality of frequencies, an impedance matrix.

The calculating, for each frequency in the plurality of frequencies, the impedance matrix, may comprise: constructing, based on the AC voltage deviations, a voltage matrix having dimensions n² x 1, wherein n is the number of electrical phases; constructing, based on the AC current deviations, a current matrix having dimensions n² x n²; and multiplying a pseudoinverse of the current matrix by the voltage matrix to obtain the impedance matrix, wherein the impedance matrix has dimensions n² x 1.

The calculating, for each frequency in the plurality of frequencies, the impedance matrix, may further comprise: converting the impedance matrix to have dimensions of n x n.

The method may further comprise storing the impedance matrix.

The constructing, based on the AC voltage deviations, the voltage matrix, may comprise constructing a plurality of voltage matrices each based on the AC voltage deviations for a respective first frequency in the plurality of frequencies. The constructing, based on the AC current deviations, the current matrix, may comprise constructing a plurality of current matrices each based on the AC current deviations for a respective second frequency in the plurality of frequencies. The method may comprise multiplying the pseudoinverse of each current matrix in the plurality of current matrices with each voltage matrix in the plurality of voltage matrices to obtain a plurality of impedance matrices having dimensions n2 x 1. The method may comprise converting the plurality of impedance matrices to a frequency-to-frequency cross-coupled impedance matrix having dimensions (pxn)x(qxn), wherein p and q are the number of frequencies in the plurality of frequencies and n is the number of electrical phases.

The determining the first AC voltage data and the first AC current data may comprise: receiving or measuring the first AC voltage measurements and the first AC current measurements; and recording the first AC voltage measurements and the first AC current measurements.

The receiving or measuring the first AC voltage measurements and the first AC current measurements may comprise receiving or measuring in the time domain over a measurement period. The measurement period may be an integer number of cycles of a fundamental operating frequency at the point of interest. For instance the measurement period may be ten cycles at a 50Hz frequency i.e., 200ms. The method may comprise applying a fast Fourier transform (FFT) to the first AC voltage measurements and the first AC current measurements. The measuring may be performed by controlling or using any suitable measuring means, such as instrument transformers.

The determining the second AC voltage data and the second AC current data may comprise: receiving or measuring the second AC voltage measurements and the second AC current measurements; and recording the second AC voltage measurements and the second AC current measurements.

The receiving or measuring the second AC voltage measurements and the second AC current measurements may comprise receiving or measuring in the time domain over a measurement period. The measurement period may be an integer number of cycles of a fundamental operating frequency at the point of interest. For instance the measurement period may be ten cycles at a 50Hz frequency i.e., 200ms. The method may comprise applying a FFT to the second AC voltage measurements and the second AC current measurements. The measuring may be performed by controlling or using any suitable measuring means, such as instrument transformers.

Each perturbation signal may comprise a sinusoidal signal. Whilst the perturbation signals may comprise square wave, triangle wave, or other signal formats, such signals may introduce harmonics into the power grid at the point of interest. Sinusoids are a purer signal that tend to enable a purer frequency response to be obtained from the power grid at the point of interest.

The plurality of interconnected systems may comprise: one or more power electronic converters; one or more AC grids; one or more synchronous generators; and/or one or more power generation networks, optionally renewable power generation networks. The renewable power generation network may comprise a wind farm, for example.

The plurality of interconnected systems may comprise a plurality of power electronic converters. The plurality of power electronic converters may be interconnected to other electrical systems of the power grid on their AC and/or DC sides. The power electronic converters may be modular multilevel converters (MMC). The power electronic converters may be voltage source converters (VSC).

The point of interest may comprise: a valve winding side of a HVDC transformer; or a line winding side of the HVDC transformer. The point of interest may be any other point in the power grid.

The predetermined frequency range may be 0 to 2500Hz. The plurality of frequencies may be separated from each other by a frequency step. The frequency step may be based on the first AC voltage data and/or the first AC current data. Expressed differently, the frequency step may be based on pre-existing distortion. The frequency step may be determined based on the requirement to ensure the level of perturbation is kept within 'small-signal' perturbation. This may mean, at certain frequencies, that the limited perturbation levels are insufficient to overcome pre-existing distortions. Accordingly, it may be necessary to inject at neighbouring frequencies, which can be of any frequency step. The frequency step may therefore be non-continuous i.e., different frequency ranges may require different frequency steps such as 0.1Hz, 1Hz, 10Hz, 50Hz. It may be necessary to avoid frequency modulation during multi-frequency injection. The frequency step may be based on the nature of the study being performed, but generally a step of 0.1Hz may be used for sub-synchronous analysis, 1Hz for stability analysis and 50Hz for harmonic performance analysis.

The polyphase power grid may comprise a three-phase power grid having three electrical phases.

The method may further comprise controlling active damping means based on the frequency dependent impedance. The active damping means may be controlled to reduce undesirable frequencies or oscillations at the point of interest, should the frequency dependent impedance identify that such frequencies are causing undesirable effects within the power grid.

The method may further comprise controlling a filtering means based on the frequency dependent impedance. The filtering means may filter one or more of the plurality of frequencies. The filtering means may be an analogue or digital filter such as a passive filter. The controlling the filtering means may comprise controlling a switch to connect or disconnect a filter. The method may determine that a power grid is susceptible to particular harmonics or other signals causing undesirable impedances. Accordingly, the method may further mitigate such impedances at specific frequencies by using the characterisation of the frequency dependent impedance to trigger, control or implement a filter. The filter may filter out undesirable frequencies of AC voltage or AC current.

The method may further comprise controlling a switch connecting one or more of the plurality of interconnected systems to the power grid. The controlling the switch may be performed in order to either connect or disconnect an electrical system to the power grid. For example, prior to connecting a new electrical system to a power grid the method may be performed to identify whether there are any undesirable frequency-related effects. If there are no such effects observed, the connection may be made. If there are effects observed, the connection may not be made. The control of the switch may be particularly relevant for multi-terminal applications where electrical systems of different manufacturers are being connecting and a testing of compatibility is required before interconnections are made.

According to a second aspect, there is provided a device for determining a frequency-dependent impedance at a point of interest in a polyphase power grid, wherein the polyphase power grid comprises a plurality of interconnected systems, the device comprising: a memory; and at least one processor; wherein the memory comprises computer-readable instructions which when executed by the at least one processor cause the device to: determine, for a point of interest in the polyphase power grid, a first AC voltage data and a first AC current data, wherein the first AC voltage data and the first AC current data respectively comprise first AC voltage measurements and first AC current measurements at a plurality of frequencies in a predetermined frequency range for each electrical phase or electrical sequence of the polyphase power grid; inject at the point of interest, for each electrical phase or on each electrical sequence, a plurality of perturbation signals, wherein the plurality of perturbation signals comprise AC current signals at the plurality of frequencies; determine, for the point of interest, a second AC voltage data and a second AC current data, wherein the second AC voltage data and the second AC current data respectively comprise second AC voltage measurements and second AC current measurements in response to each perturbation signal, wherein the AC voltage measurements and AC current measurements are at the plurality of frequencies and for each electrical phase or electrical sequence; and calculate, based on the first AC voltage data, first AC current data, second AC voltage data and the second AC current data, the frequency-dependent impedance.

The device may comprise receiving means or measurement means for determining the first AC voltage data, first AC current data, second AC voltage data, second AC current data. The receiver means may be a receiver or a transceiver. The measurement means may be an instrument transformer. The device may comprise injection means for injecting the perturbation signals. The injection means may be a transmitter or transceiver.

According to a third aspect, there is provided a computer program comprising instructions which when executed by a processor of the device of the second aspect, cause the device to perform the method of the first aspect.

According to a fourth aspect of the invention, there is provided a non-transitory computer-readable storage medium comprising the computer program of the third aspect.

It will be appreciated that particular features of different aspects share the technical effects and benefits of corresponding features of other aspects of the invention. More specifically, the device, computer program, non-transitory computer-readable medium, share the technical effects and benefits of the method.

It will also be appreciated that the use of the terms "first" and "second", and the like, are merely intended to help distinguish between similar features and are not intended to indicate a relative importance of one feature over another, unless otherwise specified.

Within the scope of this application it is expressly intended that the various aspects, embodiments, examples and alternatives set out in the preceding paragraphs, and the claims and/or the following description and drawings, and in particular the individual features thereof, may be taken independently or in any combination. That is, all embodiments and all features of any embodiment can be combined in any way and/or combination, unless such features are incompatible.

### Brief description of the drawings

Examples of the invention will now be described by way of example only and with reference to the accompanying drawings, in which:
Figure 1 shows generically, an example of a power grid in accordance with aspects of the present disclosure;
Figure 2 shows an example of a device in accordance with aspects of the present disclosure;
Figure 3 shows an example of a method in accordance with aspects of the present disclosure;
Figure 4A shows an example of a further method in accordance with aspects of the present disclosure; and
Figure 4B shows an example of further method in accordance with aspects of the present disclosure.

### Detailed description

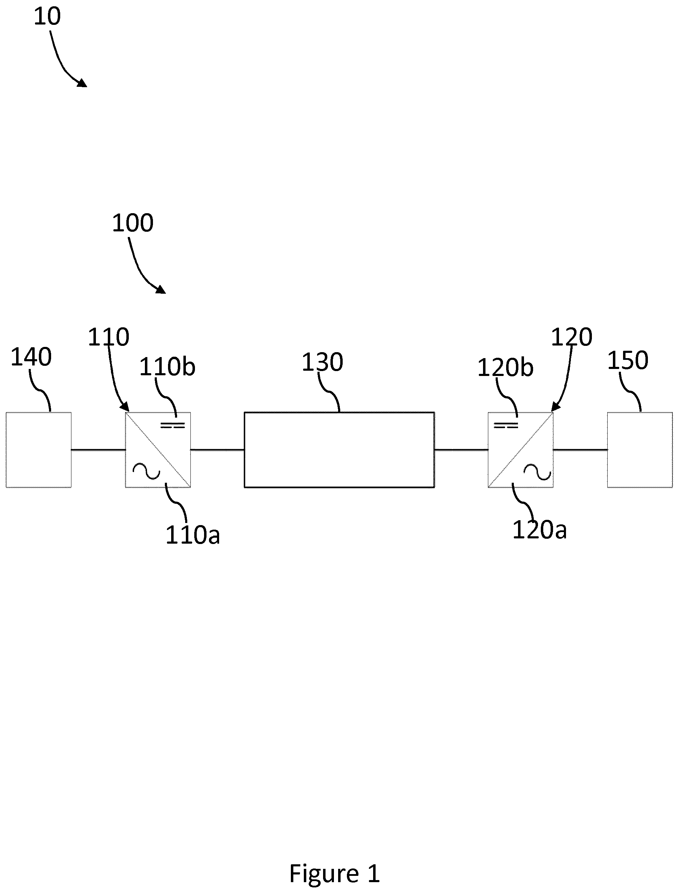

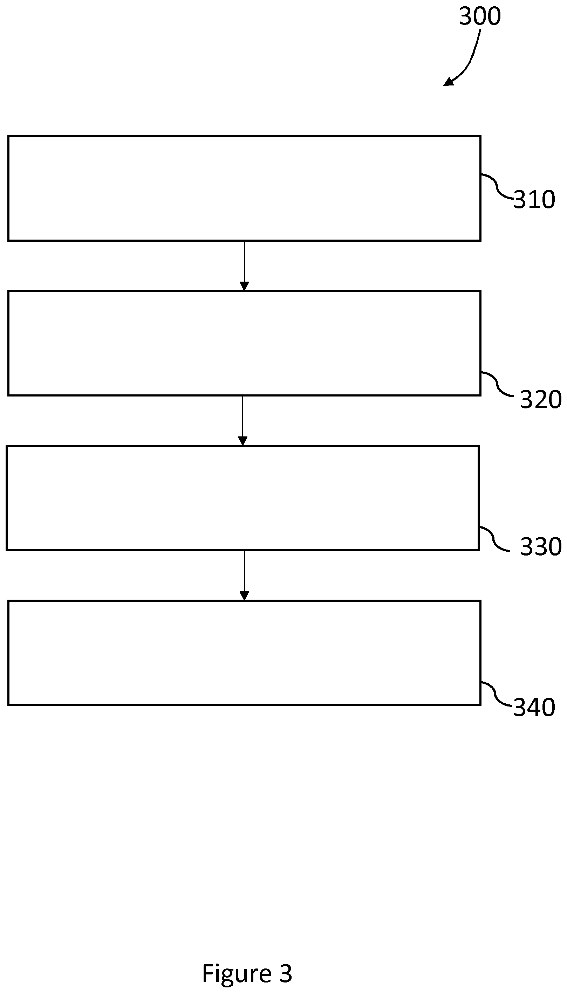

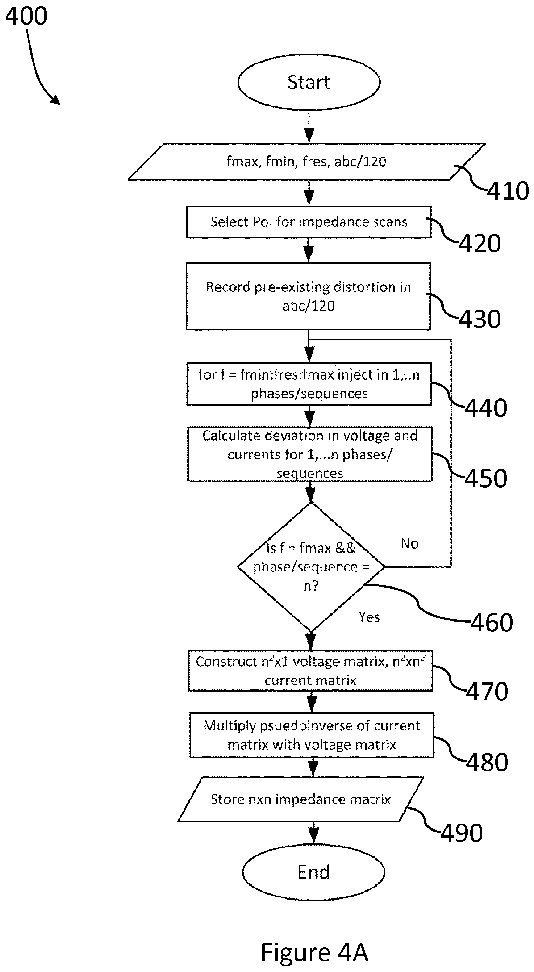

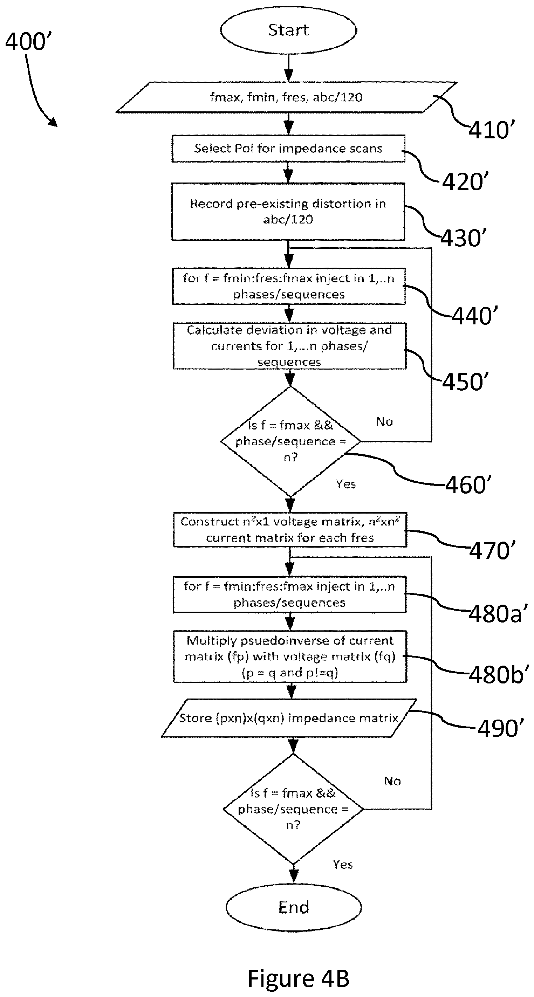

Figure 1 illustrates generically, an example of a power grid 10. The illustration is not intended to be limited to representing a particular power grid or including a particular transmission scheme, such as a monopole or bipole HVDC transmission network, but is moreover provided as a generic example illustrating principles of operation of a power grid that are useful for understanding the invention. In this manner, the power grid 10 may include, generically, a monopole or bipole scheme, or may include a multiterminal power transmission scheme, for instance. Hence whilst specific features in the illustration are shown connected to each other with a specific number of connections, it will be understood that this is not intended to be limiting either, but moreover to illustrate a generic connection between features/components. Related, is that relative dimensions or distances between components perceived in the illustration are also not intended to be limiting. It will be understood that the methods 300 and 400 of Figures 3 and 4 may be performed in the power grid 10 of Figure 1.

The power grid 10 illustrates a power transmission network 100. The power transmission network 100 includes a first power conversion means 110 (also known as a converter station) and a second power conversion means 120. The power conversion means 110, 120, convert AC power to DC power (and vice versa), acting essentially as a rectifier (when converting AC power to DC power for transmission) and an inverter (when receiving DC power and converting to AC power). The power conversion means 110, 120, may each comprise a single converter in the case of a monopole system, or two converters in the case of a bipole system. The power conversion means 110, 120, may represent a plurality of converter stations arranged as a multi-terminal power transmission system. Generically, the first power conversion means 110 comprises a first AC side 110a and a first DC side 110b. Generically, the second power conversion means 120 comprises a second AC side 120a and a second DC side 120b.

The first power conversion means 110 is connected to a first AC network 140 of power grid 10. The first AC network 140 is connected to the first AC side 110a of the first power conversion means 110.

The second power conversion means 120 is connected to a second AC network 150 of power grid 10. The second AC network 150 is connected to the second AC side 120a of the second power conversion means 120. The first AC network 140 and/or second AC network 150 may be electrical power transmission systems comprising power generation apparatus, transmission apparatus, distribution apparatus, and electrical loads. The first AC network 140 and/or second AC network 150 may comprise a renewable power generation network such as a wind-power generation network, solar-power generation network, bio-power generation network. The first AC network 140 or second AC network 150 may be a consumer network. By way of non-limiting example, the first AC network 140 may be a power generation network, with second AC network 150 being a consumer network, for instance.

Also shown is a power transmission medium 130 interconnecting the first power conversion means 110 and the second power conversion means 120. The power transmission medium 130 is connected between the first DC side 110b of first power conversion means 110 and the second DC side 120b of the second power conversion means 120. The power transmission medium 130 may comprise electrical cables and other electrical components interconnecting the first and second power conversion means 110, 120. For instance, the power transmission medium 130 may comprise a conductor providing a first electrical pole; and/or a conductor providing a second electrical pole. A neutral arrangement may also be provided interconnecting the first and second power conversion means 110, 120. The power transmission medium 130 provides the medium through which DC power is transmitted between the power conversion means 110, 120.

The operation of the power grid 10 can be generically described as follows. The first AC power generation network 140 generates AC power that is provided to first power conversion means 110 at the first AC side 110a. The first power conversion means 110 converts the received AC power to a DC power for transmission to second power conversion means 120. The DC power is transmitted from the first DC side 110b over the power transmission medium 130 to the second DC side 120b of second power conversion means 120. The second power conversion means 120 converts the received DC power back to AC power. The AC power is then provided from the second AC side 120a to the second AC network 150 for consumption, for instance. In particular examples, the power conversion means 110 and 120 may be geographically remote. For instance, the first power conversion means 110 may reside with an off-shore wind farm and the second power conversion means 120 may reside on-shore.

It will be appreciated that various other electrical components may be located at any particular location or with any particular feature/component in the power grid 10. These may include switches, transformers, resistors, reactors, surge arrestors, harmonic filters and other components well known in the art.

It will be appreciated that converters or power conversion means may comprise a number of different technologies such as voltage sourced converters (for instance using insulated gate bipolar transistor (IGBT) valves). Such converters may generally be considered to use 'power electronics'. Power electronic converters may comprise multi-level modular (MMC) converters, for instance.

It will be appreciated that cables used as power transmission mediums may comprise the following non-limiting examples of crosslinked polyethylene (XLPE) and/or mass impregnated (MI) insulation cables. Such cables may comprise a conductor (such as copper or Aluminium) surrounding by a layer of insulation. Dimensions of cables and their associated layers may be varied according to the specific application (and in particular, operational voltage requirements). Cables may further comprise strengthening or 'armouring' in applications such as subsea installation. Cables may further comprise sheaths/screens that are earthed at one or more locations.

Moreover, it will be understood that the power grid 10 may be a polyphase power grid for instance having three-phase power. In a three-phase system, three conductors supply respective first, second and third phases of AC power to a consumer. Each of the first, second and third phases will typically have equal magnitude voltages or currents, which are displaced in phase from each other by 120°.

In a three-phase power system, phase currents and voltages can be represented by three single phase components: a positive sequence component; a negative sequence component; and a zero-sequence component. For the fundamental frequency, it is the positive sequence component that rotates in phase in accordance with the power system. Hence, in the idealistic scenario, only positive sequence voltage/current will exist. It will be understood that an unbalance in voltage or current between the first, second and third-phases, of a three-phase system, in magnitude or phase angle, can give rise to undesirable negative or zero-sequence components. Such an unbalance can be caused by fault conditions, for instance in the AC networks 140, 150. For harmonic frequencies, in the presence of a fault or unbalance in harmonics, the situation can be more complex. For instance, each harmonic may include positive, negative, or zero sequence components.

The power transmission network 100 may be operated using methods such as synchronous grid forming (SGFM) wherein either or both of the power converters 110, 120 behave as three-phase, positive-phase sequence AC voltage sources behind an impedance, that operate at a frequency synchronous with over SGFM sources connected to the power transmission network 100.

The power grid 10 may further comprise a controller for controlling the operation of components of the power transmission network 100 or wider power grid 10. Such a controller may be referred to as a controller means or control means.

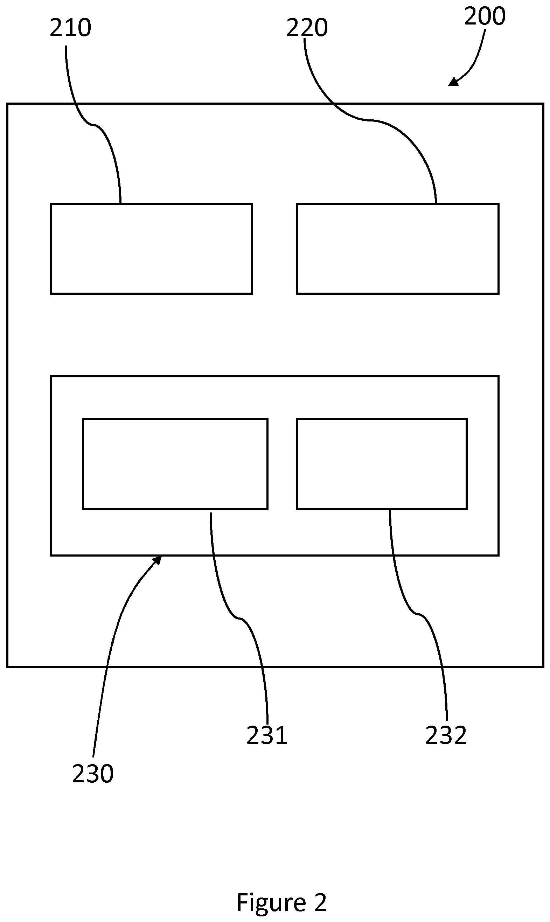

Figure 2 illustrates an example of a device 200 as may be used in implementing the invention described herein.

The device 200 may comprise a memory 210 and at least one processor 220. The memory 210 may comprise computer-readable instructions, which when executed by the at least one processor 220, cause the device 200 to perform the method/s described herein.

The device 200 is shown as comprising a transceiver arrangement 230 which may comprise a separate transmitter 231 and receiver 232. The transceiver arrangement 230 may be used to operatively communicate with other components or features of examples described herein either directly or via a further interface such as a network interface. The transceiver arrangement 230 may for instance send and receive signals using transmitter 231 and receiver 232. The signals may be controlling signals, for instance containing or defining electrical control parameters such as reference currents or reference voltages. The signals may include measured signals such as voltages or currents.

The at least one processor 220 may be capable of executing computer-readable instructions and/or performing logical operations. The at least one processor 220 may be a microcontroller, microprocessor, central processing unit (CPU), field programmable gate array (FPGA) or similar programmable controller. The controller may further comprise a user input device and/or output device. The processor 220 may be communicatively coupled to the memory 210 and may in certain examples be coupled to the transceiver 230.

The memory 210 may be a computer readable storage medium. For instance, the memory 210 may include a non-volatile computer storage medium. For example, the memory 210 may include a hard disk drive, flash memory etc.

Whilst not shown, the device 200 may additionally include a user input device interface and/or a user output device interface, which may allow for visual, audible or haptic inputs/outputs. Examples include interfaces to electronic displays, touchscreens, keyboards, mice, speakers and microphones.

Prior art approaches to characterizing power grids using frequency scanning approaches tend to consider systems in isolation that in reality are interconnected in a power grid. For example, power electronic converters tend to be characterized in isolation in the prior art. Furthermore, the prior art tends to perform frequency scanning without considering pre-existing distortions at the point of interest in a power grid. Such an approach ignores harmonic emissions. Moreover, the prior art tends to ignore cross-coupling between interconnected systems that can couple electrical phases and frequencies. Furthermore, prior art techniques tend to require initial conditions or parameters or significant knowledge of an entire control system for an interconnected system which, for various reasons (including commercial sensitivities) may not be available in reality.

The disclosure herein tends to address these drawbacks of the prior art with a novel methodology for obtaining the deviation in voltage and currents caused due to the intentional perturbation signals and solved using matrix operations. The proposed methods tend not to require any initial conditions, control design and associated parameters as input data to obtain impedance measurement. Moreover, the disclosure herein tends to produce a complete matrix representation of all possible couplings between all systems, phases/sequences, and frequencies. More specifically, the methods described herein tend to represent all possible couplings between systems, phases/sequences, and frequencies with the influence of pre-existing distortions at the point of interest; derive all possible cross-coupled impedances using only voltage and currents at the point of interest; and accurately capture all possible cross-coupled impedances detecting linearity of all interconnected systems in the power grid.

In a power transmission network, there can be several power electronic converters interfaced at the DC side, such as MMC converters in a bipole HVDC scheme. Systems that are interconnected with the power transmission network and the power electronic converters may include renewable energy sources such as solar park, wind farm, or AC grids. The method disclosed herein tend to record the pre-existing distortion for each frequency step of a frequency scan between minimum and maximum frequency ranges at a point of interest in the power grid. Then, a current source may be used to inject a perturbation signal ${{I}_{_}}_{inj}^{\left(f\right)}$ at the point of interest starting from a frequency *fₘᵢₙ*, incrementing at a desired frequency step *fᵣₑₛ,* and ending at a desired frequency *fₘₐₓ* defined by the frequency range. This process is repeated one phase (i.e., phase A/B/C) or one sequence (i.e., positive, negative, and zero), at a time. The proposed approach tends not to warrant disconnection of the interconnected systems to measure the frequency dependent impedance of the PE converter(s) and interconnected system(s).

Depending on the nature of injection (phase-wise or sequence-wise), it is important to observe the response at the point of interest of other phases or sequences both of voltages and currents. For example, in a perfectly balanced 3-phase 3-wire system, when injecting in phase a, the current must come out of the other two phases in equal proportion following Kirchoff's current law. Similarly in an unbalanced system, even though the injected current may be pure positive sequence, it is likely that the currents flowing into respective interconnected systems result in all three sequence currents. Therefore, to calculate the resulting impedances, in the phase-domain or sequence-domain, all system equations need to be considered.

In a power electronic interconnected system, it is very likely that pre-existing distortion exists at any frequency. Therefore, the proposed approach monitors these pre-existing distortions before injecting the perturbation signal at the desired frequency. The *fₛₜₑₚ* decides the resolution of the pre-existing distortion.

In an "n" phase system, there would be "n²" impedances, "n" voltages and "n" currents related to each other. For example, in a three-phase system, there are 9 impedances that include self and mutual impedances, three voltages and three currents. Using the calculated pre-existing distortion at the desired frequencies, the deviation of a given voltage and current upon injecting the perturbation signal at that frequency is calculated. This process is repeated until the injected frequency reaches *fₘₐₓ*.

For each injection, starting from phase A or positive sequence for example, the same "n" deviation in voltages and currents shall be observed. The number of injections is equal to the total number of phases, for each frequency. After "n" injections corresponding to "n" phases, there will be n² voltages and currents. These n²voltages and current are related to "n²" impedances. They are rearranged such that they can be represented in n²x1 voltage matrix, n²xn² impedance matrix and n²x1 current matrix. The impedance matrix is obtained by multiplying the pseudoinverse of the current matrix multiplied with the voltage matrix. The resulting impedance matrix is then reshaped into a nxn representation.

It is important to note that with the proposed method, non-linearity can be detected using the frequency-to-frequency coupling matrix obtained using the aforementioned procedure. The process involves iteratively replacing the voltage and current matrix for non-equal frequencies. Finally, the $\left[{Z}_{abc}^{\left(f\right)}\right]$ and $\left[{Z}_{abc}^{\left(f12\right)}\right]$ can be combined to obtain a full impedance matrix $\left[{Z}_{abc}^{\left(fpq\right)}\right]$ (where p and q are frequencies that can be equal or non-equal) that shows couplings between phases and between different frequencies. This matrix is of dimension, (pxn)x(qxn). If this matrix $\left[{Z}_{abc}^{\left(fpq\right)}\right]$ is diagonal with all off-diagonal elements to zero, the system is linear. The complete derivation of the voltage matrix, current matrix and impedance matrix will now be described.

The voltage equations at the point of interest can be expressed according to Equation 1, for each injection (phase-wise) performed, with k = a1, b1, c1, ... aN, bN, cN and each for each phase voltage measurements (k = a1, b1, c1, ... aN, bN, cN) and for each frequency (f). ${Z}_{iaN}^{\left(f\right)} ⋅ Δ {I}_{aN}^{\left(k, f\right)} + {Z}_{ibN}^{\left(f\right)} ⋅ Δ {I}_{bN}^{\left(k, f\right)} + {Z}_{icN}^{\left(h\right)} ⋅ Δ {I}_{cN}^{\left(k, f\right)}$ Equation 1

Where Z, I and V represent impedance, current and voltage respectively. Using Equation 1 for the phase a1 injection, there are N voltage equations across N different phases as expressed in Equation 2. $\begin{matrix}Δ {V}_{a 1}^{\left(k, f\right)} = {Z}_{a 1 a 1}^{\left(f\right)} ⋅ Δ {I}_{a 1}^{\left(k, f\right)} + {Z}_{a 1 b 1}^{\left(f\right)} ⋅ Δ {I}_{b 1}^{\left(k, f\right)} + {Z}_{a 1 c 1}^{\left(h\right)} ⋅ Δ {I}_{c 1}^{\left(k, f\right)} + ⋯ \\ … {Z}_{a 1 aN}^{\left(f\right)} ⋅ Δ {I}_{aN}^{\left(k, f\right)} + {Z}_{a 1 bN}^{\left(f\right)} ⋅ Δ {I}_{bN}^{\left(k, f\right)} + {Z}_{a 1 cN}^{\left(h\right)} ⋅ Δ {I}_{cN}^{\left(k, f\right)} \\ . \\ . \\ . \\ Δ {V}_{cN}^{\left(k, f\right)} = {Z}_{cNa 1}^{\left(f\right)} ⋅ Δ {I}_{a 1}^{\left(k, f\right)} + {Z}_{cNb 1}^{\left(f\right)} ⋅ Δ {I}_{b 1}^{\left(k, f\right)} + {Z}_{cNc 1}^{\left(h\right)} ⋅ Δ {I}_{c 1}^{\left(k, f\right)} + ⋯ \\ … {Z}_{cNaN}^{\left(f\right)} ⋅ Δ {I}_{aN}^{\left(k, f\right)} + {Z}_{cNbN}^{\left(f\right)} ⋅ Δ {I}_{bN}^{\left(k, f\right)} + {Z}_{cNcN}^{\left(h\right)} ⋅ Δ {I}_{cN}^{\left(k, f\right)}\end{matrix}$ Equation 2

Repeating the same exercise for N different phases, there will be N² equations in total, which can be reorganized in a matrix representation as shown in Equation 3. ${{\left[\begin{matrix}Δ {V}_{a 1}^{\left(a1,f\right)} \\ Δ {V}_{b 1}^{\left(a1,f\right)} \\ ⋮ \\ ⋮ \\ Δ {V}_{cN}^{\left(cN, f\right)}\end{matrix}\right]}_{︸}}_{\left[Δ{V}_{i}^{\left(k, f\right)}\right]} = {{\left[\begin{matrix}Δ {I}_{a 1}^{\left(a1,f\right)} & ⋯ & Δ {I}_{c 2}^{\left(aN, f\right)} \\ ⋮ & ⋱ & ⋮ \\ Δ {I}_{a 1}^{\left(cN, f\right)} & ⋯ & Δ {I}_{cN}^{\left(cN, f\right)}\end{matrix}\right]}_{︸}}_{\left[Δ{I}_{i}^{\left(k, f\right)}\right]} ⋅ {{\left[\begin{matrix}{Z}_{a 1 a 1}^{\left(f\right)} \\ {Z}_{a 1 b 1}^{\left(f\right)} \\ ⋮ \\ ⋮ \\ {Z}_{cNcN}^{\left(f\right)}\end{matrix}\right]}_{︸}}_{\left[{Z}_{abc}^{\left(f\right)}\right]}$ Equation 3

Here, $\left[Δ{V}_{i}^{\left(k, f\right)}\right]$ is a N²x1 matrix, $\left[Δ{I}_{i}^{\left(k, f\right)}\right]$ is N²x N² matrix with linear dependent rows and $\left[{Z}_{abc}^{\left(f\right)}\right]$ is a N²x1 matrix.

The $\left[{Z}_{abc}^{\left(f\right)}\right]$ matrix is simply calculated by multiplying the pseudoinverse of the $\left[Δ{I}_{i}^{\left(k, f\right)}\right]$ with the voltage matrix $\left[Δ{V}_{i}^{\left(k, f\right)}\right]$. The sequence impedance can be calculated using the $\left[{Z}_{abc}^{\left(f\right)}\right]$ matrix. Alternatively, injection can be performed in each sequence and a $\left[{Z}_{120}^{\left(f\right)}\right]$ matrix can be calculated directly.

To calculate the frequency-to-frequency cross-coupled impedance matrix, Equation 3 can be reused and solved iteratively for non-equal frequencies as shown in Equations 4 and 5. ${{{{\left[\begin{matrix}Δ {V}_{a 1}^{\left(a1,fp\right)} \\ Δ {V}_{b 1}^{\left(a1,fp\right)} \\ ⋮ \\ ⋮ \\ Δ {V}_{cN}^{\left(cN, fp\right)}\end{matrix}\right]}_{︸}}_{\left[Δ{V}_{i}^{\left(k, fp\right)}\right]} = {{\left[\begin{matrix}Δ {I}_{a 1}^{\left(a1,fq\right)} & ⋯ & Δ {I}_{c 2}^{\left(aN, fq\right)} \\ ⋮ & ⋱ & ⋮ \\ Δ {I}_{a 1}^{\left(cN, fq\right)} & ⋯ & Δ {I}_{cN}^{\left(cN, fq\right)}\end{matrix}\right]}_{︸}}_{\left[Δ{I}_{i}^{\left(k, q\right)}\right]} ⋅ {{\left[\begin{matrix}{Z}_{a 1 a 1}^{\left(fpq\right)} \\ {Z}_{a 1 b 1}^{\left(fpq\right)} \\ ⋮ \\ ⋮ \\ {Z}_{cNcN}^{\left(fpq\right)}\end{matrix}\right]}_{︸}}_{\left[{Z}_{abc}^{\left(fpq\right)}\right]}}_{︸}}_{fp \neq fq}$ Equation 4 ${{{\left[{Z}_{abc}^{\left(fpq\right)}\right]}_{\left(pxN\right) x \left(qxN\right)} = \left[\begin{matrix}{\left[{Z}_{a 1 a 1}^{\left(fpq\right)}\right]}_{pxq} & ⋯ & {\left[{Z}_{a 1 aN}^{\left(fpq\right)}\right]}_{pxq} \\ ⋮ & ⋱ & ⋮ \\ {\left[{Z}_{cNa 1}^{\left(fpq\right)}\right]}_{pxq} & ⋯ & {\left[{Z}_{cNcN}^{\left(fpq\right)}\right]}_{pxq}\end{matrix}\right]}_{︸}}_{∀ N = 1 , 2 , … n , p = q = fmin : fres : fmax}$ Equation 5

Figure 3 shows an example of a method 300 of determining a frequency-dependent impedance at a point of interest in a polyphase power grid, wherein the polyphase power grid comprises a plurality of interconnected systems.

A first step 310 comprises, determining, for a point of interest in the polyphase power grid, a first AC voltage data and a first AC current data, wherein the first AC voltage data and the first AC current data respectively comprise first AC voltage measurements and first AC current measurements at a plurality of frequencies in a predetermined frequency range for each electrical phase or electrical sequence of the polyphase power grid.

A further step 320 comprises, injecting at the point of interest, for each electrical phase or on each electrical sequence, a plurality of perturbation signals, wherein the plurality of perturbation signals comprise AC current signals at the plurality of frequencies.

A further step 330 comprises, determining, for the point of interest, a second AC voltage data and a second AC current data, wherein the second AC voltage data and the second AC current data respectively comprise second AC voltage measurements and second AC current measurements in response to each perturbation signal, wherein the AC voltage measurements and AC current measurements are at the plurality of frequencies and for each electrical phase or electrical sequence.

A further step 340 comprises, calculating, based on the first AC voltage data, first AC current data, second AC voltage data and the second AC current data, the frequency-dependent impedance.

Figure 4A shows an example of a further method 400 of determining a frequency-dependent impedance at a point of interest in a polyphase power grid, wherein the polyphase power grid comprises a plurality of interconnected systems. The method 400 explains additional steps involved in the calculation of an n x n impedance matrix in three electrical phases (abc/120) or with positive, negative and zero sequence.

A first step 410 comprises, selecting a predetermined frequency range having a maximum frequency fmax, a minimum frequency fmin and a frequency resolution fres (equivalently a frequency step fstep). The injection type i.e., phase-wise or sequence-wise may also be selected.

A further step 420 comprises, selecting a point of interest for impedance scans.

A further step 430 comprises, recording pre-existing distortions in each electrical phase abc or on each electrical sequence.

A further step 440 comprises, for each frequency (determined by fres) from fmin to fmax, injecting perturbation signals in each electrical phase or on each sequence.

A further step 450 comprises, calculating deviations in voltages and currents for each electrical phase or each sequence, in response to each perturbation signal.

A further step 460 comprises, determining whether the maximum frequency fmax has been reached and perturbation signals have been injected on all electrical phases or sequences. If the outcome of the determination is yes, then the method 400 progresses to step 470.

At step 470, the method 400 comprises constructing an n²x1 voltage matrix and an n²xn² current matrix.

A further step 480 comprises, multiplying a pseudoinverse of the current matrix with the voltage matrix.

A further step 490 comprises storing the result of step 480 as a n x n impedance matrix.

Figure 4B shows an example of a further method 400' of determining a frequency-dependent impedance at a point of interest in a polyphase power grid, wherein the polyphase power grid comprises a plurality of interconnected systems. More specifically, the method 400' is for determining a frequency-to-frequency coupling impedance matrix.

A first step 410' comprises, selecting a predetermined frequency range having a maximum frequency fmax, a minimum frequency fmin and a frequency resolution fres (equivalently a frequency step fstep). The injection type i.e., phase-wise or sequence-wise may also be selected.

A further step 420' comprises, selecting a point of interest for impedance scans.

A further step 430' comprises, recording pre-existing distortions in each electrical phase abc or on each electrical sequence.

A further step 440' comprises, for each frequency (determined by fres) from fmin to fmax, injecting perturbation signals in each electrical phase or on each sequence.

A further step 450' comprises, calculating deviations in voltages and currents for each electrical phase or each sequence, in response to each perturbation signal.

A further step 460' comprises, determining whether the maximum frequency fmax has been reached and perturbation signals have been injected on all electrical phases or sequences. If the outcome of the determination is yes, then the method 400' progresses to step 470'.

At step 470', the method 400' comprises constructing an n²x1 voltage matrix and an n²xn² current matrix for each frequency (determined by fres).

A further step 480a' and 480b' comprises, for each frequency (determined by fres) between fmin and fmax, multiplying the pseudoinverse of each current matrix (fp) with each voltage matrix (fq), wherein p be equal to or different to q.

A further step 490' comprises storing the result of step 480a' and 480b' as a (pxn) x (qxn) impedance matrix.

A number of benefits arise from the invention described herein, including that the invention tends to consider any pre-existing distortions at a point of interest in a power grid when calculating the frequency-dependent impedance at a point of interest in a power grid.

The invention described herein tends to enable the accurate characterization of frequency-dependent coupling between different power electronic systems (such as power converters), electrical phases and frequencies.

The invention described herein tends to enable the detection and characterization of all interconnected systems in a power grid.

The invention described herein tends to enable the characterization of the frequency-dependent impedances of all interconnected systems in a power grid without warranting their disconnection.

The invention described herein tends to enable improved design of controllers to mitigate potential interactions between different power electronic converters.

The invention described herein tends to aid the harmonic performance of the power electronic converter.

The invention described herein tends to have the advantage of de-risking harmonic resonance issues and thereby mitigating power transmission network and/or power grid tripping. Accordingly, loss of revenue arising from such tripping tends to be prevented.

The invention described herein tends to have the advantage of mitigating the maloperation of equipment and the potential failure of such equipment as a result.

Reference throughout this specification to an example of a particular method or apparatus, or similar language, means that a particular feature, structure, or characteristic described in connection with that example is included in at least one implementation of the method and apparatus described herein. The terms "including", "comprising", "having", and variations thereof, mean "including but not limited to", unless expressly specified otherwise. An enumerated listing of items does not imply that any or all of the items are mutually exclusive, unless expressly specified otherwise. The terms "a", "an", and "the" also refer to "one or more", unless expressly specified otherwise.

As used herein, a list with a conjunction of "and/or" includes any single item in the list or a combination of items in the list. For example, a list of A, B and/or C includes only A, only B, only C, a combination of A and B, a combination of B and C, a combination of A and C or a combination of A, B and C. As used herein, a list using the terminology "one or more of" includes any single item in the list or a combination of items in the list. For example, one or more of A, B and C includes only A, only B, only C, a combination of A and B, a combination of B and C, a combination of A and C or a combination of A, B and C. As used herein, a list using the terminology "one of" includes one, and only one, of any single item in the list. For example, "one of A, B and C" includes only A, only B or only C and excludes combinations of A, B and C. As used herein, "a member selected from the group consisting of A, B, and C" includes one and only one of A, B, or C, and excludes combinations of A, B, and C." As used herein, "a member selected from the group consisting of A, B, and C and combinations thereof" includes only A, only B, only C, a combination of A and B, a combination of B and C, a combination of A and C or a combination of A, B and C.

Aspects of the disclosed method and apparatus are described with reference to schematic flowchart diagrams and/or schematic block diagrams of methods, apparatuses, systems, and program products. It will be understood that each block of the schematic flowchart diagrams and/or schematic block diagrams, and combinations of blocks in the schematic flowchart diagrams and/or schematic block diagrams, can be implemented by code. This code may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the schematic flowchart diagrams and/or schematic block diagrams.

The schematic flowchart diagrams and/or schematic block diagrams in the Figures illustrate the architecture, functionality, and operation of possible implementations of apparatuses, systems, methods, and program products. In this regard, each block in the schematic flowchart diagrams and/or schematic block diagrams may represent a module, segment, or portion of code, which includes one or more executable instructions of the code for implementing the specified logical function(s).

It will be appreciated that numerical values recited herein are merely intended to help illustrate the working of the invention and may vary depending on the requirements of a given power transmission network, component thereof, or power transmission application.

The listing or discussion of apparently prior-published documents or apparently prior-published information in this specification should not necessarily be taken as an acknowledgement that the document or information is part of the state of the art or is common general knowledge.

Preferences and options for a given aspect, feature or parameter of the invention should, unless the context indicates otherwise, be regarded as having been disclosed in combination with any and all preferences and options for all other aspects, features and parameters of the invention.

The disclosure herein provides a method for characterization of the frequency-dependent behavior of multiple interconnected power electronic converters in a power grid, the method comprising: recording a pre-existing distortion at a point of interest in the power grid for each frequency between a minimum and a maximum frequency in a pre-defined frequency range; injecting, using a current source, a perturbation signal at the point of interest, at each frequency step of a plurality of steps in the pre-defined frequency range; repeating the injecting step for each phase (i.e., phases A/B/C) or on each sequence (i.e., positive, negative, and zero) at a time; determining, based on the recorded pre-existing distortion at each frequency, a deviation of a voltage and a current at the point of interest for all the phases or sequences in the interconnected systems, upon injecting the perturbation signal at that frequency step; and calculating based on the determined voltage and current deviations at each frequency step, an impedance matrix (i.e., an n x n matrix or (pxn)x(qxn)) for all interconnected systems.

## Claims

1. A method of determining a frequency-dependent impedance at a point of interest in a polyphase power grid, wherein the polyphase power grid comprises a plurality of interconnected systems, the method comprising:
determining, for a point of interest in the polyphase power grid, a first alternating current 'AC' voltage data and a first AC current data, wherein the first AC voltage data and the first AC current data respectively comprise first AC voltage measurements and first AC current measurements at a plurality of frequencies in a predetermined frequency range for each electrical phase or electrical sequence of the polyphase power grid;
injecting at the point of interest, for each electrical phase or on each electrical sequence, a plurality of perturbation signals, wherein the plurality of perturbation signals comprises AC current signals at the plurality of frequencies;
determining, for the point of interest, a second AC voltage data and a second AC current data, wherein the second AC voltage data and the second AC current data respectively comprise second AC voltage measurements and second AC current measurements in response to each perturbation signal, wherein the second AC voltage measurements and second AC current measurements are at the plurality of frequencies and for each electrical phase or electrical sequence; and
calculating, based on the first AC voltage data, first AC current data, second AC voltage data and the second AC current data, the frequency-dependent impedance.

2. The method of claim 1, wherein the calculating, based on the first AC voltage data, first AC current data, second AC voltage data and the second AC current data, the frequency-dependent impedance, comprises:
determining a plurality of AC voltage and AC current deviations for each frequency in the plurality of frequencies and for each electrical phase or electrical sequence, wherein the AC voltage and AC current deviations are based on the first AC voltage data, the first AC current data, the second AC voltage data and the second AC current data; and then
calculating, based on the plurality of AC voltage and AC current deviations, the frequency-dependent impedance.

3. The method of claim 2, wherein the calculating, based on the plurality of AC voltage and AC current deviations, the frequency-dependent impedance, comprises calculating, for each frequency in the plurality of frequencies, an impedance matrix.

4. The method of claim 3, wherein the calculating, for each frequency in the plurality of frequencies, the impedance matrix, comprises:
constructing, based on the AC voltage deviations, a voltage matrix having dimensions n² x 1, wherein n is the number of electrical phases;
constructing, based on the AC current deviations, a current matrix having dimensions n² x n²; and
multiplying a pseudoinverse of the current matrix by the voltage matrix to obtain the impedance matrix, wherein the impedance matrix has dimensions n² x 1.

5. The method of claim 4, wherein the calculating, for each frequency in the plurality of frequencies, the impedance matrix, further comprises:
converting the impedance matrix to have dimensions of n x n.

6. The method of claim 4, wherein:
the constructing, based on the AC voltage deviations, the voltage matrix, comprises constructing a plurality of voltage matrices each based on the AC voltage deviations for a respective first frequency in the plurality of frequencies;
the constructing, based on the AC current deviations, the current matrix, comprises constructing a plurality of current matrices each based on the AC current deviations for a respective second frequency in the plurality of frequencies; and
multiplying the pseudoinverse of each current matrix in the plurality of current matrices with each voltage matrix in the plurality of voltage matrices to obtain a plurality of impedance matrices having dimensions n² x 1; and then
converting the plurality of impedance matrices to a frequency-to-frequency cross-coupled impedance matrix having dimensions (pxn)x(qxn), wherein p and q are the number of frequencies in the plurality of frequencies and n is the number of electrical phases.

7. The method of any one of the preceding claims, wherein the determining the first AC voltage data and the first AC current data comprises:
receiving or measuring the first AC voltage measurements and the first AC current measurements; and
recording the first AC voltage measurements and the first AC current measurements.

8. The method of any one of the preceding claims, wherein the determining the second AC voltage data and the second AC current data comprises:
receiving or measuring the second AC voltage measurements and the second AC current measurements; and
recording the second AC voltage measurements and the second AC current measurements.

9. The method of any one of the preceding claims, wherein each perturbation signal comprises a sinusoidal signal.

10. The method of any one of the preceding claims, wherein the plurality of interconnected systems comprises:
one or more power electronic converters;
one or more AC grids;
one or more synchronous generators; and/or
one or more power generation networks, optionally renewable power generation networks.

11. The method of any one of the preceding claims, wherein the point of interest comprises:
a valve winding side of a high voltage direct current 'HVDC' transformer; or
a line winding side of the HVDC transformer.

12. The method of any one of the preceding claims, wherein the predetermined frequency range is 0 to 2500Hz and the plurality of frequencies are separated from each other by a frequency step.

13. The method of any one of the preceding claims, wherein the polyphase power grid comprises a three-phase power grid having three electrical phases.

14. The method of any one of the preceding claims, further comprising at least one of:
controlling active damping means based on the frequency dependent impedance;
controlling a filtering means based on the frequency dependent impedance; and
controlling a switch connecting one or more of the plurality of interconnected systems to the power grid.

15. A device for determining a frequency-dependent impedance at a point of interest in a polyphase power grid, wherein the polyphase power grid comprises a plurality of interconnected systems, the device comprising:
a memory; and
at least one processor;
wherein the memory comprises computer-readable instructions which when executed by the at least one processor cause the device to:
determine, for a point of interest in the polyphase power grid, a first AC voltage data and a first AC current data, wherein the first AC voltage data and the first AC current data respectively comprise first AC voltage measurements and first AC current measurements at a plurality of frequencies in a predetermined frequency range for each electrical phase or electrical sequence of the polyphase power grid;
inject at the point of interest, for each electrical phase or on each electrical sequence, a plurality of perturbation signals, wherein the plurality of perturbation signals comprises AC current signals at the plurality of frequencies;
determine, for the point of interest, a second AC voltage data and a second AC current data, wherein the second AC voltage data and the second AC current data respectively comprise second AC voltage measurements and second AC current measurements in response to each perturbation signal, wherein the second AC voltage measurements and second AC current measurements are at the plurality of frequencies and for each electrical phase or electrical sequence; and
calculate, based on the first AC voltage data, first AC current data, second AC voltage data and the second AC current data, the frequency-dependent impedance.
